Europäisches Patentamt

European Patent Office

Office européen des brevets

(19)

(11) EP 0 631 382 B1

(12) EUROPÄISCHE PATENTSCHRIFT

(45) Veröffentlichungstag und Bekanntmachung des Hinweises auf die Patenterteilung:
09.05.2001 Patentblatt 2001/19

(51) Int Cl.⁷: H03G 3/20, H03G 3/30, H04B 7/00

(21) Anmeldenummer: 94108817.1

(22) Anmeldetag: 08.06.1994

(54) **Verfahren zur Optimierung der automatischen Verstärkereinstellung in Funkempfängern**

Method for optimising the automatic adjustment of an amplifier in an rf-receiver

Méthode d'optimisation de l'ajustement automatique d'un amplificateur dans un poste de réception hautes fréquences

(84) Benannte Vertragsstaaten:
DE SE

(30) Priorität: 25.06.1993 DE 4321210

(43) Veröffentlichungstag der Anmeldung:
28.12.1994 Patentblatt 1994/52

(73) Patentinhaber: SIEMENS
AKTIENGESELLSCHAFT
80333 München (DE)

(72) Erfinder:
• Eul, Hermann-Josef, Dr.
D-85764 Oberschleissheim (DE)
• Metzner, Norbert, Dipl.-Ing.
D-91757 Treuchtlingen (DE)

(56) Entgegenhaltungen:
EP-A- 0 616 435        GB-A- 2 229 609

• COMMUNICATION FOR GLOBAL USERS.
COMMUNICATION THEORY MINI CONFERENC,
ORLANDO, DEC. 6 - 9, 1992, Bd. MINI
CONFERENCE, Nr. -, 6.Dezember 1992
INSTITUTE OF ELECTRICAL AND
ELECTRONICS ENGINEERS, Seiten 46-50, XP
000366396 YOW-JONG LIU 'PERFORMANCE OF
A CODE DIVISION MULTIPLE ACCESS (CDMA)
SYSTEM WITH POWER CONTROL FOR
CELLULAR AND PERSONAL
COMMUNICATIONS'

**Beschreibung**

Die Erfindung bezieht sich auf ein Verfahren zur Optimierung der automatischen Verstärkereinstellung in Funkempfängern, insbesondere Mobilfunkempfängern in einem zellularen Mobilfunknetz mit Basisstationen in einer gegenseitigen räumlichen Anordnung.

In herkömmlichen HF-Empfängern werden zur Ausgleichung zeitlich schwankender Empfangsleistungen Verstärker mit einer oder mehreren variablen Verstärkerstufe(n) eingesetzt (AGC = Automatic Gain Control).

Im Bereich des Mobilfunks tritt das Problem der schwankenden Empfangsleistung in äußerst verschärfter Form auf. Außerdem werden im Mobilfunk zur effizienten Aufrechterhaltung der Übertragungsqualität Sendeleistungsregelungen eingesetzt. Das Zusammentreffen dieser Tatsachen erschwert die Auslegung der automatischen Verstärkungsregelung außerordentlich. Die zur schwankenden Sendeleistung hinzukommende zusätzliche aktive Veränderung der Sendeleistung führt zu einer vom Empfänger nur sehr bedingt zu bewältigenden Situation.

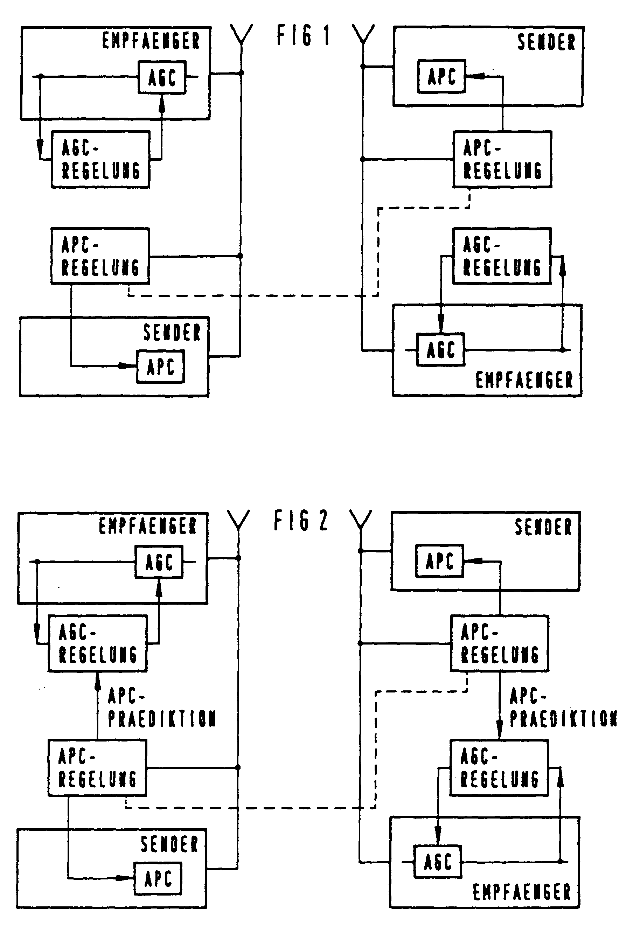

Herkömmliche AGC-Schleifen verwenden ausschließlich Empfangspegel der Vergangenheit zur Festlegung des AGC-Wertes für die Zukunft. Hierbei wird z.B. die AGC auf den Mittelwert des Empfangspegels des letzten Meßintervalls, beispielsweise in der letzten Sekunde eingestellt. Eine solche Anordnung zeigt das Blockschaltbild nach Figur 1, bei der zwei miteinander kommunizierende Funkstationen dargestellt sind, zwischen denen zeitlich sich ändernde Übertragungsverluste auftreten. Jede Funkstation enthält einen Empfänger E mit einer AGC-Regelung und einen Sender S mit einer APC-Regelung (APC = Adaptiv Power Control). Zwischen beiden APC-Regelungen besteht eine logische Verbindung (strichliert eingezeichnet).

Verbleibende Schwankungen müssen durch hinreichend großzügige Auslegung des Dynamikbereichs der Empfangsstufen abgedeckt sein. Dies bedeutet bei den heute üblichen Digitalempfängern, daß der Analog-Digital-Wandler mit einer genügend großen Wortbreite ausgelegt sein muß, um auf der einen Seite eine Übersteuerung sicher zu vermeiden und auf der anderen Seite noch eine hinreichend gute Auflösung des Signals sicherzustellen.

Der Erfindung liegt die Aufgabe zugrunde, ein Verfahren anzugeben, um in der Empfangsstation eine Vorhersage über das Empfangsleistungsverhalten zu treffen.

Diese Aufgabe wird mit einem Verfahren gemäß Anspruch 1 gelöst.

Vorteilhafte Ausgestaltungen und Weiterbildungen des Erfindungsgegenstandes sind in den Unteransprüchen angegeben.

Nachstehend wird die Erfindung anhand von in der Zeichnung dargestellten Ausführungsbeispielen näher erläutert.

Es zeigen:

Figur 2     in einer schematischen Darstellung ähnlich Figur 1 eine Prädikator-Lösung und

Figur 3     im Blockschaltbild das Zusammenwirken von AGC und APC in einem Mobilfunksystem mit einer Basisstation und einer Mobilstation und

Figur 4     im Blockschaltbild ein Mobilfunksystem mit Sendeleistungsregelung der Mobilstation.

In modernen Mobilfunksystemen kommt der Sendeleistungsregelung eine besondere Bedeutung zur Erreichung optimaler Netzkapazität zu. Dies erschwert auf der einen Seite die Aufgabe der empfängerseitigen AGC der Gegenstation. Das erfindungsgemäße Verfahren macht sich jedoch andererseits die Tatsache zunutze, daß diesem Sendeleistungs-Regelungs-Algorithmus wichtige Informationen vorliegen, die zu einer verbesserten Prädiktion der zu erwartenden Empfangsleistung ausgewertet werden können. Diese Einbeziehung der Sendeleistungsregelung der einen Station und den dadurch zu erwartenden Veränderungen in die Prädiktion der zu erwartenden Empfangsleistung der anderen Station ist in Figur 2 gezeigt. Bei dieser ist, in Ergänzung zu Figur 1 die Verknüpfung von Sendeleistungsregelung und automatischer Verstärkungsregelung des Empfängers dargestellt. Hierfür ist in jeder Funkstation eine zusätzliche Verbindung von der APC-Regelung zur AGC-Regelung eingezeichnet. Wesentlich ist dabei, daß die Prädiktion nicht nur auf Werten der Vergangenheit beruht, sondern auch die zu erwartenden Veränderungen der Sendeleistung mit einbezieht. Damit gelingt eine zuverlässigere Einstellung der automatischen Verstärkungsregelung, was sich in geringeren Anforderungen an die eingangs erläuterte großzügige Auslegung des Dynamikbereiches wiederspiegelt. Kann beispielsweise die erforderliche Wortbreite des AD-Wandlers um zwei Bit reduziert werden, verringern sich einerseits die Herstellungskosten, andererseits eröffnet sich unter Umständen sogar der Vorstoß in grundsätzlich vorteilhaftere Realisierungsmöglichkeiten aufgrund der mit abnehmender Wortbreite zunehmenden Wandlergeschwindigkeiten.

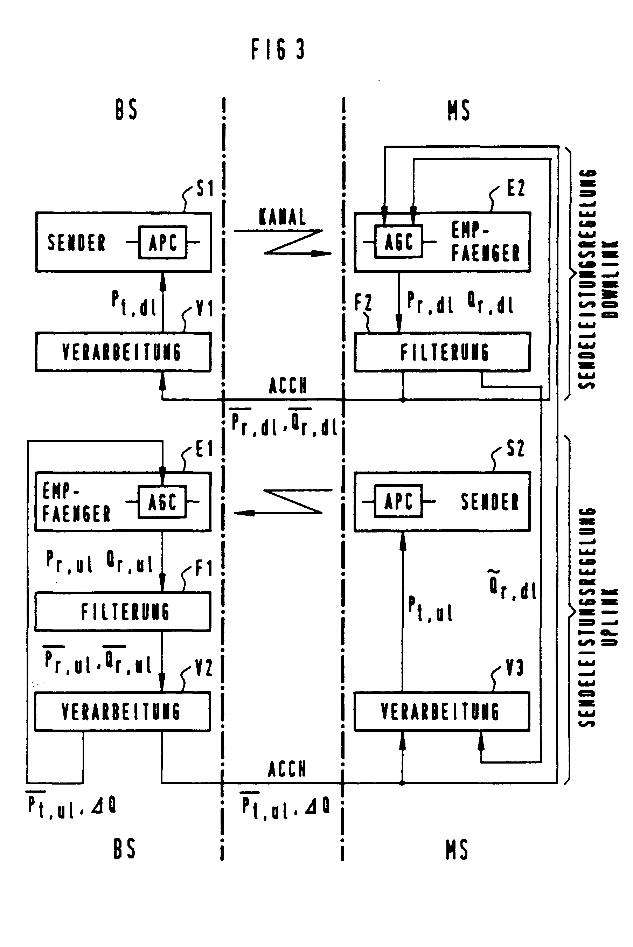

Figur 3 zeigt als Ausführungsbeispiel ein Mobilfunksystem mit einer Basisstation BS und einer Mobilstation MS in gegenseitiger räumlicher Anordnung unter Verwendung eines Verfahrens zur Sendeleistungsregelung einer Mobilstation. Ein solches Verfahren zur Sendeleistungsregelung ist in der Patentanmeldung P 43 08 904.6 der Anmelderin beschrieben.

Die Basisstation BS ist auf der linken Seite der Figur 3 dargestellt, die Mobilstation auf der rechten Seite. Zwischen beiden befindet sich ein Funkfeld. Die Basisstation BS enthält einen Sender S mit einer APC, die mit einer Einheit V1 zur Signalverarbeitung (Algorithmus zur Regelung der Sendeleistung einer BS) verbunden ist, die über einen assoziierten Kontrollkanal (ACCH) mit dem Ausgang eines Filters F2 auf der Empfangsseite der Mobilstation in Verbindung steht. Der Eingang des Filters F2 ist mit dem eine AGC enthaltenden Empfänger E2 der Mobilstation MS verbunden. In dieser Ebene erfolgt die Sendeleistungsregelung Downlink, d.h. die Regelung der Sendeleistung der Basisstation.

Die Basisstation BS enthält ferner einen Empfänger E1 mit einer AGC, dem ein Filter F1 und eine nachfolgende Signalverarbeitung V2 (Algorithmus zur (hier Langzeit-)Regelung der Sendeleistung einer MS) nachgeschaltet sind. Ein Ausgang der Signalverarbeitung ist nun mit dem Empfängereingang E1 verbunden. Über diese Verbindung werden Daten der Sendeleistungsregelung der AGC im Empfänger E1 zur Prädiktion der zu erwartenden Empfangsleistung übermittelt. Ein zweiter Ausgang von V2 ist über einen assoziierten Kontrollkanal (ACCH) mit einer Einrichtung V3 zur Signalverarbeitung (Algorithmus zur (hier Kurzzeit-)Regelung der Sendeleistung einer MS) auf der Sendeseite der Mobilstation MS verbunden. Ein zweiter Eingang der Verarbeitung V3 ist mit einem zweiten Ausgang des dem Empfänger E2 der Mobilstation nachgeschalteten Filter F2 verbunden, während der Ausgang der Verarbeitung V3 mit dem Sender S2 der Mobilstation MS verbunden ist. Ferner ist eine Verbindung vom Filterausgang F2 zur AGC im Empfänger E2 der Mobilstation vorgesehen sowie eine Verbindung über den Kontrollkanal von der Verarbeitung V2 der Basisstation BS zur AGC des Empfängers E2 in der Mobilstation MS. Über diese beiden Verbindungen erhält die AGC im Empfänger E2 Daten aus den Sendeleistungsregelungen zur Prädiktion der zu erwartenden Empfangsleistung. Die untere Ebene in der Darstellung zwischen Sender S2 der Mobilstation MS und Empfänger E1 der Basisstation BS beinhaltet die Sendeleistungsregelung für den Uplink.

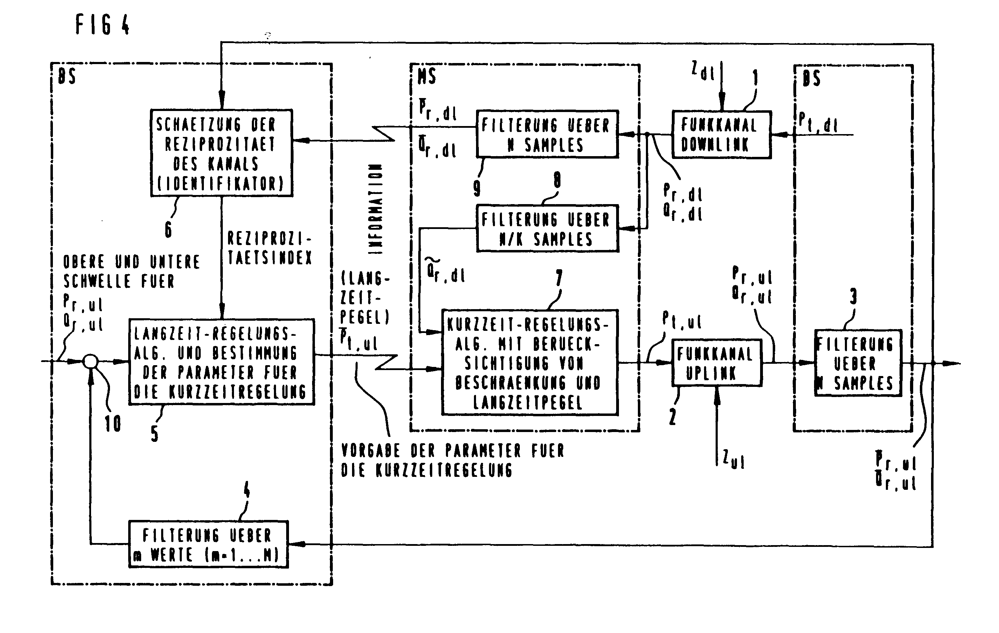

Zum besseren Verständnis des erfindungsgemäßen Verfahrens zur Optimierung der automatischen Verstärkereinstellung in Funkempfängern, insbesondere Mobilfunkempfängern in einem zellularen Mobilfunknetz soll zunächst die in das Verfahren mit einbezogene Sendeleistungsregelung, wie sie in der vorstehend genannten Patentanmeldung angegeben ist, anhand der Figur 4 beschrieben werden.

In Figur 4 sind die Mobilstation MS und die Basisstation BS jeweils durch strichliert gezeichnete Kästchen dargestellt, wobei für eine übersichtliche Darstellung der Regelkreise die Basisstation BS beiderseits der Mobilstation MS eingezeichnet ist. Zwischen Basisstation und Mobilstation liegt der Funkkanal 1 (Downlink), in der entgegengesetzten Übertragungsrichtung von der Mobilstation MS zur Basisstation BS der Funkkanal 2 (Uplink). Die auf dem Funkkanal auftretenden Störungen sind mit $Z_{dl}$ bzw. $Z_{ul}$ bezeichnet und durch einen auf die jeweiligen Kästchen 1 und 2 gerichteten Pfeil markiert.

Die Steuerung der Langzeit-Sendeleistung $P_{t,ul}$ der Mobilstation MS erfolgt in der Basisstation aufgrund folgender Größen:
über N Samples ($\overset{\wedge}{=}$ T1) gefilterte Empfangsleistung $P_{r,ul}$ und N Samples ($\overset{\wedge}{=}$ T1) gefilterte Empfangsqualität $Q_{r,ul}$ des Uplink, wobei die Filterung (z.B. Mittelung) im Filter 3 der Basisstation BS erfolgt sowie über die als O & M-Parameter vorgegebenen Schwellwerte für diese beiden Größen. Diese werden als obere und untere Schwelle für Empfangsleistung und Empfangsqualität auf einen zweiten Eingang eines Subtraktionsgliedes 10 gegeben, das ausgangsseitig mit einem den Langzeit-Regelungs-Algorithmus und Bestimmung der Parameter für die Kurzzeitregelung enthaltenden Kästchen 5 verbunden ist. Die ermittelten Werte der Empfangsleistung und Empfangsqualität am Ausgang des Filters 3 können noch einer weiteren Filterung, z.B. einer gleitenden Mittelung, über m-Werte unterworfen werden. Dies erfolgt in dem im Verbindungsweg zwischen Filterausgang 3 und Subtraktionsglied 10 der Basisstation angeordneten Filter 4. Der O & M-Parameter m ist unter anderem vom Zelltyp und der Zellgröße abhängig.

Bei diesem Verfahren wird zusätzlich in der Basisstation aus den von ihr selbst ermittelten Filterergebnissen $\bar{P}_{r,ul}$ und $\bar{Q}_{r,ul}$ sowie aus den ihr von der Mobilstation mitgeteilten Daten der gefilterten Empfangswerte $\bar{P}_{r,dl}$ und $\bar{Q}_{r,dl}$ des Downlink eine Aussage über die Reziprozität des Funkkanals getroffen. Diese Schätzung der Reziprozität des Kanals (Identifikation) erfolgt in der im Verbindungsweg von Filter 3 und Einrichtung 5 angeordneten Einrichtung 6. Das Ergebnis der Schätzung wird als Reziprozitätsindex der Einrichtung 5 zugeführt und unverändert zusammen mit dem Langzeitpegel $\bar{P}_{t,ul}$ als Vorgabe der Parameter für die Kurzzeitregelung der Mobilstation MS übermittelt, die eine Einrichtung 7 für den Kurzzeit-Regelungs-Algorithmus unter Berücksichtigung von Beschränkung und Langzeitpegel enthält.

Um die Sendeleistung $P_{t,ul}$ der Mobilstation MS so realitätsnah wie möglich steuern zu können, wird der Mobilsstation MS begrenzte Entscheidungsbefugnis übertragen. Zur Limitierung des damit verbundenen Signalisierungsaufwandes fußt die Steuerung der in der Mobilstation implementierten unteren Schicht auf Messungen des Downlink. Hierfür wird die Empfangsqualität $Q_{r,dl}$ in der Mobilstation MS über N/K-Samples ($\overset{\wedge}{=}$ T2) gefiltert. K ist ein O & M-Parameter, der nach oben durch die Ausfilterung des fast-fading begrenzt wird, d.h. eine Mindestanzahl von Samples ist erforderlich, um das fast-fading auszufiltern und das slow-fading verläßlich zu ermitteln. Gleichzeitig ist K ein Maß für die Aktualität der Steuerung, d.h. für K = 1 erfolgt die Steuerung nur nach dem Langzeitwert $\bar{P}_{t,ul}$. Das gefilterte Ausgangssignal $\tilde{q}_{r,dl}$ des Filters 8 wird auf einen Eingang der Einrichtung 7 gegeben.

Da der Mobilstation die globale Ausbreitungssituation nicht bekannt ist, wird dem Kurzzeit-Regelungs-Algorithmus der vorstehend bereits behandelte Identifikator übergeordnet, mit dem die zulässige Richtung und die maximale Änderung der Kurzzeit-Sendeleistung $P_{t,ul}$ bestimmt werden. Zusätzlich kann als weiterer stabilisierender Faktor die zulässige Änderungsrichtung und der maximal zulässige Betrag von der Art und Höhe der letzten Änderung von $\bar{P}_{t,ul}$ abhängig gemacht werden.

Bei der weiteren Beschreibung des erfindungsgemäßen Verfahrens wird zunächst der Uplink betrachtet, bei dem die Mobilstation der Sender und die Basisstation der Empfänger ist. In der Basisstation sind zur Regelung ihrer eigenen Sendeleistung als auch zur Regelung der Sendeleistung einer ihr zugeordneten Mobilstation folgende Daten bekannt:

a) Der gefilterte Downlink-Empfangspegel $\bar{P}_{r,dl}$ sowie die gefilterte Downlink-Empfangsqualität $\bar{Q}_{r,dl}$ (diese Daten werden der Basisstation von der Mobilstation über einen assoziierten Kontrollkanal ACCH mitgeteilt),
b) der Uplink-Empfangspegel $P_{r,ul}$ sowie die Uplink-Empfangsqualität $Q_{r,ul}$ auf Burst-Ebene,
c) der gefilterte Uplink-Empfangspegel $\bar{P}_{r,ul}$ sowie die gefilterte Uplink-Empfangsgualität $\bar{Q}_{r,ul}$,
d) die einzustellende Sendeleistung der Basisstation $\bar{P}_{t,dl}$ als Ergebnis des Regelungsalgorithmusses und
e) die Langzeit-Sendeleistung der Mobilstation $\bar{P}_{t,ul}$ sowie ein Reziprozitätsindex $\Delta Q$ als Ergebnis des Langzeit-Regelungsalgorithmusses.

Die Basisstation verfügt somit über genaue Kenntnisse des Übertragungskanals. Ferner ist ihr bekannt, um welchen Betrag und in welcher Richtung sich die Langzeit-Sendeleistung der Mobilstation zu einem bestimmten Zeitpunkt ändern wird. Zusätzlich kennt die Basisstation den Selbststeuerungsbereich der Mobilstation. Stellt der APC-Regelungsmechanismus die Informationen über die bevorstehenden Veränderungen der MS-Sendeleistung der AGC-Regelung in der Basisstation zur Verfügung, so ist diese in der Lage, ihren Dynamikbereich auf diese Veränderungen auszurichten. Zudem kann der Dynamikbereich enger gefaßt werden.

Beim Downlink ist die Basisstation der Sender, die Mobilstation der Empfänger. In der Mobilstation sind zur Regelung ihrer eigenen Sendeleistung als auch zur Regelung der Sendeleistung der zugeordneten Basisstation folgende Daten bekannt:

a) Der Downlink-Empfangspegel $\bar{P}_{r,dl}$ sowie die Downlink-Empfangsqualität $Q_{r,dl}$ auf Burst-Ebene,
b) der gefilterte Downlink-Empfangspegel $\bar{P}_{r,dl}$ sowie die gefilterte Downlink-Empfangsqualität $\bar{Q}_{r,dl}$,
c) die Langzeit-Sendeleistung der Mobilstation $\bar{P}_{t,ul}$ sowie ein Reziprozitätsindex $\Delta Q$ als Ergebnis des Langzeit-Regelungsalgorithmusses in der Basisstation, die über einen assoziierten Kontrollkanal (ACCH) an die Mobilstation MS übertragen werden,
d) das angepeilte Qualitätsmaß der Funkverbindung, das aus der Funkverbindungsaufbau-Prozedur bekannt ist, sowie
e) die einzustellende Sendeleistung der Mobilstation $P_{t,ul}$ als Ergebnis des Regelungsalgorithmus.

Durch die Untersuchung des gefilterten Downlink-Empfangspegels $\bar{P}_{r,dl}$ sowie der gefilterten Downlink-Empfangsqualität $\bar{Q}_{r,dl}$ unter Berücksichtigung des angepeilten Qualitätsmaßes ist die Mobilstation in der Lage, bevorstehende Änderungen der Basisstations-Sendeleistung zu erkennen. Zur Präzisierung dieser Erkenntnis dienen die Parameter Langzeit-Sendeleistung der Mobilstation $\bar{P}_{t,ul}$ und der Reziprozitätsindex $\Delta Q$. Aus der Veränderung des aktuellen Wertes der Langzeit-Sendeleistung der Mobilstation $\bar{P}_{t,ul}$ gegenüber dem vorhergehenden Wert sowie der Aussage über die Reziprozität zwischen Up- und Downlink kann die AGC-Regelung in der Mobilstation den Betrag der Änderung ableiten. Somit ist die AGC-Regelung in der Lage, ihren Dynamikbereich auf diese Veränderungen auszurichten und ihren Dynamikbereich enger zu fassen.

## Patentansprüche

**1.** Verfahren zur Optimierung der automatischen Verstärkereinstellung in Funkempfängern in einem zellularen Mobilfunknetz mit Basisstationen und Mobilstationen, bei dem

a) Sendeleistungs-Regelungsdaten einer ersten Station an eine zweite Station übertragen und zur Regelung der Verstärkereinstellung des Empfängers der zweiten Station verwendet werden,
wobei aus einer Kenntnis der Sendeleistungs-Regelungsdaten der ersten Station eine Prädiktion der zu erwartenden Empfangsleistung der zweiten Station der automatischen Verstärkungsregelung (AGC) des Empfängers der zweiten Station zugeführt wird , oder
b) aus Sendeleistungsregelungsdaten einer ersten Station Daten zur Regelung der Verstärkereinstellung der Empfängers einer zweiten Station ermittelt und an diese übertragen und zur Regelung der Verstärkereinstellung des Empfängers der zweiten Station verwendet werden, wobei aus einer Kenntnis dieser von der ersten Station übertragenen Daten eine Prädiktion der zu erwartenden Empfangsleistung der zweiten Station der automatischen Verstärkungsregelung (AGC) des Empfängers der zweiten Station zugeführt wird.

**2.** Verfahren nach Anspruch 1, dadurch gekennzeichnet, daß die Prädiktion der zu erwartenden Empfangsleistung aus der gegenseitigen Kenntnis von Daten zur Regelung der eigenen Sendeleistung als auch zur Regelung der Sendeleistung der jeweils zugeordneten korrespondierenden Station erfolgt.

**3.** Verfahren nach Anspruch 2, dadurch gekennzeichnet, daß die Prädiktion der zu erwartenden Empfangsleistung aus der Kenntnis von Daten, die zur Regelung der eigenen Sendeleistung oder der jeweils zugeordneten korrespondierenden Station erfaßt bzw. ermittelt werden, erfolgt.

**4.** Verfahren nach Anspruch 3, dadurch gekennzeichnet,daß die Daten zur Regelung der Sendeleistung aus einem aus zwei Schichten bestehenden hierarchischen System gewonnen werden, derart, daß in der oberen Schicht, die eine eine Basisstation und eine Mobilstation umfassende geschlossene Regelschleife bildet, die Regelung der Langzeit-Sendeleistung $\bar{P}_{t,ul}$ der Mobilstation in der Basisstation erfolgt (Langzeitregelung) und daß zusätzlich in der Basisstation eine Aussage über die Entscheidungsbefugnis der unteren Schicht getroffen und diese der Mobilstation übermittelt wird, und daß in der unteren Schicht, die eine in der Mobilstation implementierte lokale Regelung darstellt, unter Berücksichtigung der von der Basisstation ermittelten Langzeit-Sendeleistung und der Aussage über die Entscheidungsbefugnis der unteren Schicht die Kurzzeit-Sendeleistung $P_{t,ul}$ der Mobilstation ermittelt wird (Kurzzeitregelung).

## Claims

**1.** Method for optimizing the automatic adjustment of an amplifier in radio receivers in a cellular mobile radio network with base stations and mobile stations, in the case of which

> a) transmitter power control data of a first station are transmitted to a second station and used to control the amplifier adjustment of the receiver of the second station, knowledge of the transmitter power control data of the first station being used to supply a prediction of the expected receiver power of the second station to the automatic gain control (AGC) of the receiver of the second station, or
> b) data for controlling the amplifier adjustment of the receiver of a second station are determined from transmitter power control data of a first station and are transmitted to the second station and used to control the amplifier adjustment of the receiver of the second station, knowledge of these data transmitted by the first station being used to supply a prediction of the expected receiver power of the second station to the automatic gain control (AGC) of the receiver of the second station.

**2.** Method according to Claim 1, characterized in that the expected receiver power is predicted from the mutual knowledge of data for controlling the transmitter power of a given station and for controlling the transmitter power of the respectively assigned corresponding station.

**3.** Method according to Claim 2, characterized in that the expected receiver power is predicted from knowledge of data which are detected and/or determined for the purpose of controlling the transmitter power of a given station or of the respectively assigned corresponding station.

**4.** Method according to Claim 3, characterized in that the data for controlling the transmitter power are obtained from a hierarchical system comprising two layers, this being done in such a way that in the upper layer, which forms a closed loop comprising a base station and a mobile station, the long-term transmitter power $P_{t,ul}$ of the mobile station is controlled in the base station (long-term control), in that, in addition, a statement on the decision-making authority of the lower layer is made in the base station and transmitted to the mobile station, and in that the short-term transmitter power $P_{t,ul}$ of the mobile station is determined (short-term control) in the lower layer, which constitutes a local control implemented in the mobile station, taking account of the long-term transmitter power determined by the base station and of the statement on the decision-making authority of the lower layer.

## Revendications

**1.** Procédé d'optimisation du réglage automatique d'un amplificateur de récepteurs de radiocommunication dans un réseau cellulaire de radiocommunication mobile à station de base et à station mobile, dans lequel :

> a) des données de régulation de puissance d'émission d'une première station sont transmises à une deuxième station et sont utilisées pour réguler le réglage d'amplificateur du récepteur de la deuxième station, une prédiction de la puissance de réception à attendre de la deuxième station étant, à partir d'une connaissance des données de régulation de puissance d'émission de la première station, envoyée à la commande automatique de gain (AGC) du récepteur de la deuxième station, ou
> b) des données pour la régulation du réglage d'amplificateur du récepteur d'une deuxième station sont déterminées à partir des données de régulation de puissance d'émission d'une première station et transmises à la deuxième station et sont utilisées pour réguler le réglage d'amplificateur du récepteur de la deuxième station, une prédiction de la puissance de réception à attendre de la deuxième station à partir d'une connaissance des données transmises par la première station étant envoyée à la commande automatique de gain (AGC) du récepteur de la deuxième station.

2. Procédé suivant la revendication 1, caractérisé en ce que la prédiction de la puissance de réception à attendre s'effectue à partir de la connaissance mutuelle de données pour la régulation de la puissance d'émission propre ainsi que pour la régulation de la puissance d'émission de la station correspondante associée.

3. Procédé suivant la revendication 2, caractérisé en ce que la prédiction de la puissance de réception à attendre s'effectue à partir de la connaissance de données qui sont détectées ou déterminées pour la régulation de la puissance d'émission propre ou de la station correspondante associée.

4. Procédé suivant la revendication 3, caractérisé en ce que les données pour la régulation de la puissance d'émission sont obtenues à partir d'un système hiérarchisé constitué de deux couches, de telle manière que, dans la couche supérieure, qui forme une boucle de régulation fermée comprenant une station de base et une station mobile, la régulation de la puissance $P_{t,ul}$ d'émission de longue durée de la station mobile s'effectue dans la station de base (régulation de longue durée) et que, de plus, dans la station de base, une assertion sur l'autorisation de décision de la couche intérieure est prise et transmise à la station mobile, et que, dans la couche inférieure, qui représente une régulation locale mise en oeuvre dans la station mobile, la puissance $P_{t,ul}$ d'émission de brève durée de la station mobile est déterminée (régulation de brève durée) en tenant compte de la puissance d'émission de longue durée déterminée par la station de base et de l'assertion sur l'autorisation de décision de la couche inférieure.

FIG 1

FIG 2

FIG 3

**BS**

**MS**

SENDELEISTUNGSREGELUNG
DOWNLINK

S1

SENDER — APC

KANAL

AGC — EMP-FAENGER

E2

$P_{t,dl}$

V1

VERARBEITUNG

$P_{r,dl}$ $Q_{r,dl}$

F2

FILTERUNG

ACCH

$\overline{P_{r,dl}} \cdot \overline{Q_{r,dl}}$

E1

EMP-FAENGER — AGC

S2

APC — SENDER

$P_{r,ul}$ $Q_{r,ul}$

F1

FILTERUNG

$\overline{P_{r,ul}} \cdot \overline{Q_{r,ul}}$

V2

VERARBEITUNG

$P_{t,ul}$

$\tilde{Q}_{r,dl}$

V3

VERARBEITUNG

ACCH

$\overline{P_{t,ul}} \cdot \Delta Q$

$\overline{P_{t,ul}} \cdot \Delta Q$

**BS**

**MS**

SENDELEISTUNGSREGELUNG
UPLINK

FIG 4

EP 0 631 382 B1